(19) Europäisches Patentamt
European Patent Office
Office européen des brevets

(11) **EP 4 687 277 A1**

(12) **EUROPEAN PATENT APPLICATION**

(43) Date of publication:
**04.02.2026 Bulletin 2026/06**

(21) Application number: **24382831.6**

(22) Date of filing: **30.07.2024**

(51) International Patent Classification (IPC):
*H02M 3/07* (2006.01)     *H02M 1/08* (2006.01)
*H02M 1/00* (2006.01)     *H03K 3/03* (2006.01)
*H03L 7/099* (2006.01)

(52) Cooperative Patent Classification (CPC):
**H02M 3/07; H02M 1/0006; H02M 1/007;
H02M 1/08; H02M 3/071; H03K 3/0315**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Universitat Politècnica De Catalunya
08034 Barcelona (ES)**

(72) Inventors:
• **FERNÁNDEZ MARTÍNEZ, Daniel
08780 Pallejà (ES)**

• **SÁNCHEZ CHIVA, José María
08034 Barcelona (ES)**
• **NIKSERESHT, Sasan
08034 Barcelona (ES)**
• **COSP VILELLA, Jordi
08034 Barcelona (ES)**
• **MADRENAS BOADAS, Jordi
08034 Barcelona (ES)**

(74) Representative: **Torner, Juncosa I Associats, SL
C / Pau Claris, 108, 1r 1a
08009 Barcelona (ES)**

(54) **LIGHT ENERGY HARVESTING INTEGRATED CIRCUIT**

(57) A light energy harvesting integrated circuit is proposed. It comprises a main energy harvester including a negative photodiode (1) to harvest light energy from incident light and to generate a negative voltage (5) as a result; and a power management stage including: a first charge pump (2) to invert the generated negative voltage (5) into a positive voltage; a second charge pump (3) to boost the positive voltage a given pumping factor at an output of the light energy harvesting integrated circuit; and a clock generator (6) to generate complementarily clock driving signals ($\phi_1$, $\phi_2$) to drive the first and second charge pumps (2, 3), the second charge pump (3) being further driven using clock drivers (9).

**Fig. 2**

Processed by Luminess, 75001 PARIS (FR)

EP 4 687 277 A1

**Description**

**TECHNICAL FIELD**

The present invention generally relates to integrated circuits. More specifically, the invention relates to a light energy harvesting integrated circuit that particularly comprises integrated monolithic photovoltaic structures and a power management circuit that can extract energy from incident light and that are capable of powering circuits.

**BACKGROUND OF THE INVENTION**

Integrated circuit production process can be divided into two main different stages. On one hand, FEOL (Front-End of Line) consists in the fabrication of active and passive devices like transistors, diodes, and resistors. On the other hand, BEOL (Back-End of Line) consist in the fabrication of the interconnection layer that connect the aforementioned electrical components as well as the fabrication of capacitors. FEOL process fabricates a series of layers and regions on the base Silicon by depositing a series of materials to change the electrical properties of the Silicon. These materials usually are phosphorous, arsenic or antimony to generate n-doped regions or boron, aluminum or gallium to generate p-doped regions. N-dope regions are those with an excess of electrons in the Silicon crystalline structure, while p-doped regions are those with a lack of electrons.

As explained above, these regions are used to create integrated components on an integrated circuit with which one can create complex circuits such as microprocessors. A side-effect of CMOS (Complementary Metal Oxide Semiconductor) integrated circuit fabrication process is the existence of parasitic photodiodes in the circuit. Photodiodes are the components used to create photovoltaic cells and consist of a junction of p-doped and an n-doped regions. The intersection of these two regions create the so called depletion regions where the free electrons of the n-doped region move towards the near p-doped regions to fill the holes and otherwise. When this region is illuminated, photons of sufficient energy strike the junction, creating electron-hole pairs that move in opposite directions, creating a current across the device with the so called photoelectric effect. The generated current can, thus, be used for different applications. A very popular one is the implementation of CMOS cameras, but they can also be used to supply circuits than can be integrated on the same integrated circuit in what is known as light energy harvesting.

Several photodiodes can be created in an integrated circuit depending on the p- and n-doped regions available in a standard CMOS process. [1] discloses all the available combinations that include positive or negative output photodiodes depending on the connection of the output terminals:

a) Positive photodiode: NW/P+, DNW/PW & N+/PW
b) Negative photodiode: P+/NW & P-Sub/NW, P-Sub/DNW & PW/DNW & PW/N+, P-Sub/DNW | PW/N,

where the notation used is the following:

- P+, N+: p and n doped regions (most superficial doping profile)
- NW, PW: p- and n- Wells (deeper doping profile)
- DNW: Deep-n Well (the deepest doping profile)
- P-Sub: the p-doped Silicon base
- Photodiodes in parallel have been indicated with "&" and in series with "|".

Photon recollection efficiency is the highest in larger surfaces and photodiodes with a thicker depletion regions. Besides, combinations of photodiodes connection that result in various diodes in parallel result is higher photo-generated currents, while in series result in higher voltages. As described in [1] and [2], the most efficient diode combination in the one using P-Sub/DNW and PW/DNW in parallel, as it consists of deeper and larger photodiodes. Such photodiode is a negative one, and has been proven that it is between 1.75 and 3.25 times more efficient than the available best positive photodiode, depending on the technology used [1].

Recent technical advances from academic research have turned out, in the last years, in the foundation of several companies that commercialize Internet of Things (IoT) miniaturized solutions. These solutions, though, rely on the use of batteries that limit the size of these devices. Moreover, battery replacement is a complex issue, especially for large Wireless Sensor Networks (WSN), not to mention the ecological footprint during fabrication and disposal of batteries. In the last years, energy harvesting solutions have been proposed as a solution to power miniaturized devices and to avoid the use of batteries. Among all the proposed solutions, the use of the aforementioned described on-chip light energy harvesting is the most promising one in terms of system integration and small size.

The main limitation of such photodiodes is their low output voltage, usually <0.5 V, which makes the design of circuits, especially analog circuits, really challenging due to the limited headroom available to properly bias the circuits and the low dynamic range. In a standard CMOS process, only one natural combination allow series photodiodes in an efficient manner. Unfortunately, output current is limited by the photodiodes providing the lower current, which is the thinner and/or smallest one, thus, the less efficient one. [3] proposes a strategy to stack photodiodes using a standard CMOS process, but the efficiency is well below 1%, which is not interesting for energy harvesting. A solution for this problem was proposed in [4], but it requires complex and expensive post-processing of the manufactured chip, and the PD present in the standard CMOS are not used.

In order to increase the available voltage to supply electronic circuits, several strategies have been proposed. [5-7] propose the use of a dual supply using a positive photodiode as a positive and a negative photodiode as a negative supply, effectively doubling the available supply voltage. The disadvantage of this strategy is the need to size the inefficient positive photodiode 1.75 to 3.25 times larger in order to compensate the lower energy extraction and to equal the negative photodiode, increasing the overall area.

The use of DC-DC converters has also been proposed in the literature to increase the available voltage. [8] proposes a parallel-series switched capacitor charge pump to pump the output voltage. This strategy can be implemented on-chip, but still requires a positive and inefficient photodiode. The alternative solution proposed in the article is the use of an inductor to implement an inductor based DC-DC converter. This solution is similar to [9]. The use of such converter results in a very efficient voltage pumping, but requires external off-the-shelf components that importantly increase the system volume. This solution was also explored in [10], but in addition of the inductor size, no monolithic photodiodes are used.

[11] proposes a combination of a reduced Dickson and Series-Parallel charge pump to allow an ultralow power and low voltage start up. However, it only relies on the positive photodiode. Similarly, [12] proposes a nested x3 charge pump capable of efficiently pump the voltage a 3 factor, which is enough to supply integrated circuits. However, their use of positive photodiode only requires a higher area to get the same power than a negative photodiode could harvest.

New and improved light energy harvesting integrated circuits are therefore needed.

References

[1] U. Çilingiroǧlu, B. Tar and Ç. Ozmen, "On-Chip Photovoltaic Energy Conversion in Bulk-CMOS for Indoor Applications," in IEEE Transactions on Circuits and Systems I: Regular Papers, vol. 61, no. 8, pp. 2491-2504, Aug. 2014, doi: 10.1109/TCSI.2014.2304652.
[2] G. Moayeri Pour, M. K. Benyhesan and W. D. Leon-Salas, "Energy Harvesting Using Substrate Photodiodes," in IEEE Transactions on Circuits and Systems II: Express Briefs, vol. 61, no. 7, pp. 501-505, July 2014, doi: 10.1109/TCSII.2014.2327371.
[3] M. K. Law and A. Bermak, "High-Voltage Generation With Stacked Photodiodes in Standard CMOS Process," in IEEE Electron Device Letters, vol. 31, no. 12, pp. 1425-1427, Dec. 2010, doi: 10.1109/LED.2010.2075910.

[4] Chang-Hong ShenJia-Min ShiehWen-Hsien HuangTsung-Ta WuChih-Chao YangTung-Ying Hsieh, "Chip with light energy harvester,", USA patent no. US2017/0110444A1.

[5] B. Tar and U. Çilingiroǧlu, "Nanowatt-Scale Power Management for On-Chip Photovoltaic Energy Harvesting Beacons," in IEEE Journal on Emerging and Selected Topics in Circuits and Systems, vol. 4, no. 3, pp. 284-291, Sept. 2014, doi: 10.1109/JETCAS.2014.2337192.
[6] J. Madrenas, D. Fernández and C. Wang, "LCMOS: Light-powered standard CMOS circuits," 2012 IEEE International Symposium on Circuits and Systems (ISCAS), Seoul, Korea (South), 2012, pp. 3029-3032, doi: 10.1109/ISCAS.2012.6271957.
[7] J. Madrenas, J. M. Sánchez-Chiva, D. Fernández and J. Cosp, "Design Considerations for Analog LCMOS Harvest-Use Integrated Signal Processing," 2019 IEEE International Symposium on Circuits and Systems (ISCAS), Sapporo, Japan, 2019, pp. 1-5, doi: 10.1109/ISCAS.2019.8702469.
[8] S. Ghosh, H. -T. Wang and W. D. Leon-Salas, "A Circuit for Energy Harvesting Using On-Chip Solar Cells," in IEEE Transactions on Power Electronics, vol. 29, no. 9, pp. 4658-4671, Sept. 2014, doi: 10.1109/TPEL.2013.2273674.
[9] H. Kim, J. Maeng, I. Park, J. Jeon, D. Lim and C. Kim, "A 90.2% Peak Efficiency Multi-Input Single-Inductor Multi-Output Energy Harvesting Interface With Double-Conversion Rejection Technique and Buck-Based Dual-Conversion Mode," in IEEE Journal of Solid-State Circuits, vol. 56, no. 3, pp. 961-971, March 2021, doi: 10.1109/JSSC.2020.3025722.
[10] Eugen Tiefnig, "Micro-energy harvester for battery free applications," USA patent no. US2017/0133938A1.
[11] Wu et al. - "A 20-pW Discontinuous Switched-Capacitor Energy Harvester for Smart Sensor Applications".
[12] X. Liu and E. Sánchez-Sinencio, "An 86% Efficiency 12 $\mu$W Self-Sustaining PV Energy Harvesting System With Hysteresis Regulation and Time-Domain MPPT for IOT Smart Nodes," in IEEE Journal of Solid-State Circuits, vol. 50, no. 6, pp. 1424-1437, June 2015, doi: 10.1109/JSSC.2015.2418712.

**DESCRIPTION OF THE INVENTION**

To that end, present invention provides a light energy harvesting integrated circuit that comprises a first (or main) energy harvester and a power management stage. The main energy harvester includes a negative photodiode to harvest light energy from incident light and to generate a negative voltage as a result. The power management stage comprises a first charge pump to invert the generated negative voltage into a positive voltage; a second charge pump to boost the positive voltage a given pumping factor at an output of the light energy harvesting integrated circuit; and a clock generator to generate complementarily clock driving signals to drive the first and second charge pumps. Additionally, the second charge pump is further driven via clock drivers.

Present invention improves the efficiency of on-chip light energy harvesting systems by containing, integrated on the same chip and manufactured in the same standard CMOS process, the negative photodiode acting as the main energy harvester, and the power management stage that increases the voltage to supply circuits.

In some embodiments, the clock generator is a light-supplied clock generator.

In some embodiments, the clock generator is powered by a second (or secondary) energy harvester that includes a negative photodiode and a positive photodiode.

In some embodiments, dimensions of the negative and positive photodiodes are sized to provide the same energy to the clock generator.

In some embodiments, the clock drivers are supplied by the negative voltage and an output voltage of the first charge pump, which is similar to the positive voltage.

In some embodiments, the clock generator comprises a ring oscillator that is configured to operate at an oscillation frequency based on the intensity of the incident light. Additionally, in some embodiments, the integrated circuit has a Maximum Power Point Tracker (MPPT) circuit connected thereto. Therefore, such dependence of the clock frequency on light intensity can be used by the MPPT.

In some embodiments, a load is connected to the output of the light energy harvesting integrated circuit.

In some embodiments, the given pumping factor is four. This is achieved by connecting a negative terminal of the load to the negative voltage and by using it as a floating ground. In other embodiments, the given pumping factor is three by connecting the negative terminal of the load to ground.

The load can comprise a resistor. Alternatively, the load can comprise a low dropout regulator that can adjust the boosted positive voltage. Alternatively, the load can comprise a battery charging circuit.

In some embodiments, the load can also comprise a reservoir capacitor (11) to store the boosted positive voltage. The reservoir capacitor can comprise any of an on chip Metal-Insulator-Metal, Metal-Oxide-Metal, or Metal-Oxide Semiconductor Capacitor; or off-the-shelf capacitors or supercapacitors; or even a battery.

## BRIEF DESCRIPTION OF THE DRAWINGS

The previous and other advantages and features will be more fully understood from the following detailed description of embodiments, with reference to the attached figures, which must be considered in an illustrative and non-limiting manner, in which:

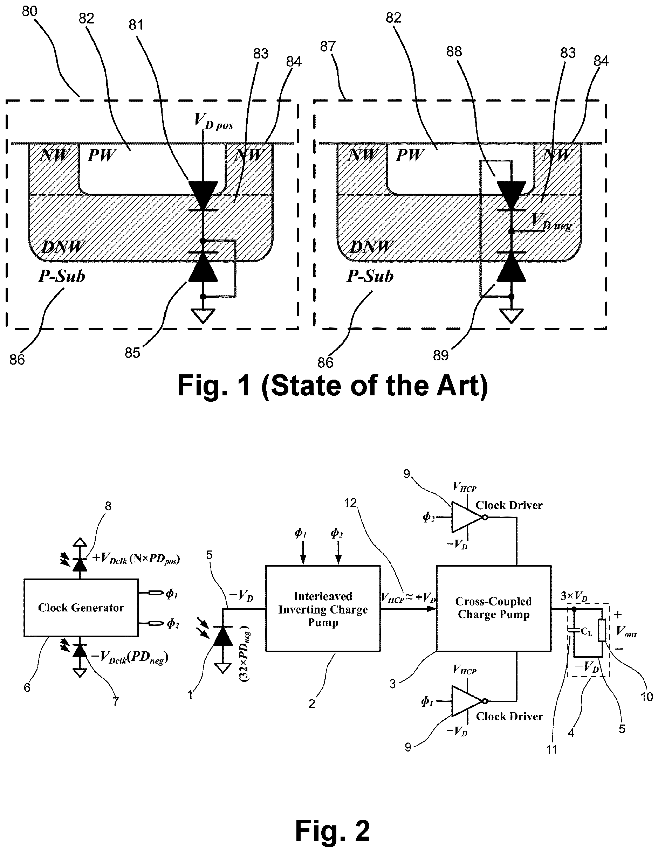

Fig. 1 is a cross-section of a standard CMOS process FEOL, with the photodiodes that can be used to power the clock generator. Positive photodiode 80 (on the left) is made up of a single diode 81 formed by the p-n junction between the PW 82 and DNW 83 (and NW 84) since the other diode 85, made up by the P-Sub 86 and DNW 83 (and NW 84) implants, is shorted as it is reversed biased. Negative photodiode 87 (on the right) is formed by two parallel p-n junctions: the diode 88 formed by the PW 82 and DNW 83 (and NW 84) and the diode 89 formed by the P-Sub 86 and the DNW 83 (and NW 84). The positive photodiode 80 is only used to generate the light harvested clock, whereas the negative photodiode 87, which provides more energy, is used as the main supply.

Fig. 2 is a block-level schematic of the proposed light energy harvesting integrated circuit, according to an embodiment of the present invention.

Fig. 3 is the transistor-level schematic of the ring oscillator of the clock generator, including the supply photodiodes, according to an embodiment of the present invention.

Fig. 4 is the transistor-level schematic of the two charge pumps, including the input supply photodiode and the output capacitor for energy storage and a resistor to model the load, according to an embodiment of the present invention.

Fig. 5 is a simplified schematic that depicts the working principle of the first charge pump, according to an embodiment of the present invention.

Fig. 6 is a simplified schematic that depicts the working principle of the second charge pump, according to an embodiment of the present invention.

## DETAILED DESCRIPTION OF THE INVENTION AND OF PREFERRED EMBODIMENTS

Fig. 2 illustrates an embodiment of the proposed light energy harvesting integrated circuit, or simply integrated circuit from now on. The integrated circuit includes a large monolithic negative photodiode 1 that acts as main energy harvester, efficiently harvesting light energy to generate a negative output voltage. It also includes a power management stage that comprises a first charge pump 2, known as Interleaved Inverting Charge Pump (IICP); a second charge pump 3, referred to as Cross-Coupled Charge Pump (CCCP); and clock generator (6), and more particularly, a light-supplied clock generator, to drive these charge pumps 2, 3. The first charge pump 2 inverts the negative voltage into a positive voltage, while the second charge pump 3 further boosts this positive voltage by a given pumping factor at the integrated circuit output.

Particularly, the clock generator 6 is powered by an additional energy harvester formed by a negative photodiode 7 and a positive photodiode 8, designed with the FEOL structure shown in Fig. 1 and sized to obtain the same energy, making the clock generator 6 self-powered. Additionally, clock drivers 9 are used in order to drive the second charge pump 2 with a clock between -VD 5 and VIICP 12. That is, the negative and positive voltages obtained from the negative photodiode 1 that supplies the entire integrated circuit.

The second charge pump 2 can provide different pumping factors. For instance, a 4x pumping factor is achieved by connecting the negative terminal of the load 4 to the negative voltage -VD 5, while a 3x pumping factor is achieved by connecting the load's negative terminal to ground.

The illustrated load 4 comprises a resistor 10 and a reservoir capacitor 11. In other embodiments, this circuit may be implemented differently. For example, in some embodiments (not shown) the reservoir capacitor 11 may not be present, making the load circuit 4 to consume the energy at the same moment it is harvested in a harvest-use approach. In other embodiments, element 10 may consist of a Low Dropout (LDO) regulator, that can adjust the voltage to any value in order to accommodate the output voltage the value required by the circuit used as a load. This LDO can also serve to remove noise, ripple, voltage variations, etc. from the output voltage. Alternatively, element 10 could be implemented as a battery charger circuit, efficiently charging a battery, such as but not limited to, a Li-ion battery.

If included, the reservoir capacitor 11 may be implemented by Metal-Insulator-Metal (MIM), Metal-Oxide-Metal (MOM) capacitor or Metal Oxide Semiconductor capacitor (MOSCAP) on-chip capacitors. Alternatively, it can be an off-chip storage capacitor, such as, but not limited to, an electrolytic, ceramic, tantalum, or film capacitors, or a supercapacitor. It may also be implemented on-chip through a post-process manufacturing over the BEOL layers or even as a battery.

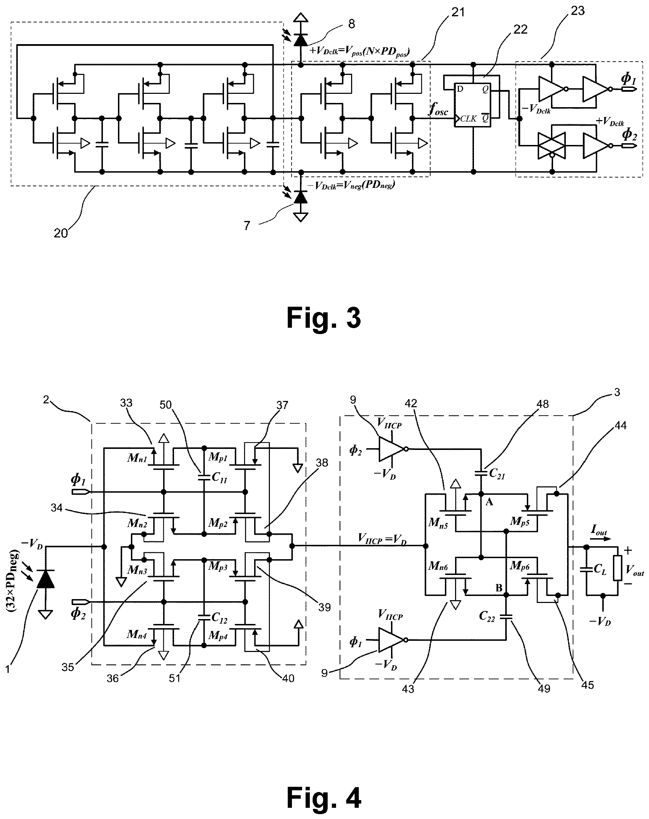

Fig. 3 illustrates an embodiment of the clock generator 6. In this embodiment, the circuit is divided into four primary stages: a ring oscillator 20, a buffer 21, a D flip-flop 22 that produces a signal with a 50% duty cycle, and a phase splitter 23 that generates the two complementary clock signals to drive the charge pumps 2, 3. The ring oscillator 20, particularly a 3-stage ring oscillator, provides a high frequency clock. This circuit is powered by a specifically designed matrix of photodiode configurations which include 24 cells of parallel positive photodiodes 8 providing a +VD voltage, and 4 cells of parallel negative photodiodes 7 providing a -VD voltage. As explained before, each photodiode, and specifically each matrix thereof, is specifically sized to match the photo-generated current of both photodiodes: at low voltage, the photodiodes work as current sources, so ring oscillator 20 works in current starved configuration. Matching the diodes power makes the oscillator rise and fall times symmetric. The oscillation frequency $f_{osc}$ of the ring oscillator 20 is directly proportional to the photo-generated current as described by the following equation:

$$f_{osc} = \frac{I_{PD}}{2nC_{tot}(2V_D)},$$

where $I_{PD}$ is the photo-generated current, n denotes the number of inverter stages in the ring oscillator, $C_{tot}$ is the sum of output and input capacitances of a single stage, and $V_D$ is the photodiode voltage.

As $I_{PD}$ is proportional to incident light, the oscillation frequency is a function of light intensity. Such dependence of the clock frequency on light intensity can be used by a Maximum Power Point Tracker (MPPT) circuit to maximize energy extraction from the photodiode by adjusting some parameters of the charge pumps 2, 3.

Fig. 4 depicts an embodiment of the transistor-level schematic of the two charge pumps 2, 3. The first charge pump 2 includes transistors $M_{n1}$ to $M_{n4}$ and $M_{p1}$ to $M_{p4}$ 33 - 44 and is driven by the negative photodiode 1. The second charge pump 3 comprises transistors $M_{n5}$ 42, $M_{n6}$ 43, $M_{p5}$ 44, and $M_{p6}$ 45, as well as the clock buffers 9. On-chip MIM capacitors 48 and 49 are the main capacitors of the first charge pump 2. The same capacitor type is used for capacitors $C_{11}$ 50 and $C_{22}$ 51.

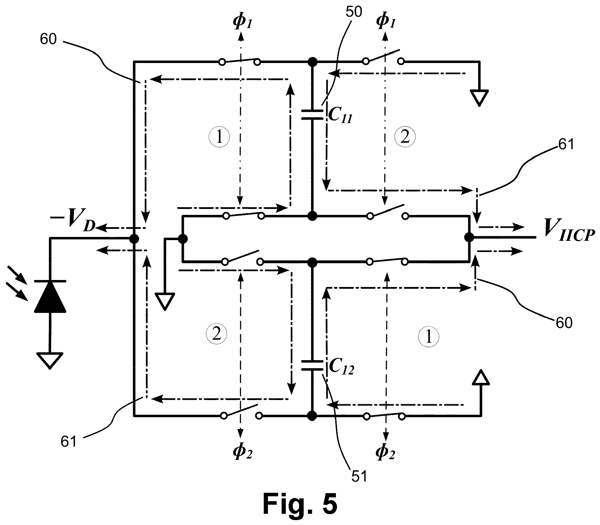

Fig. 5 illustrates an embodiment of the operation of the first charge pump 2 during two semi-periods: a first semi-period (Phase 1) shown by arrows 60 and a second semi-period (Phase 2) shown by arrows 61. For clarity, the transistors are depicted as on-off switches. The charge pump operates in two phases based on the clock signals. In Phase I, $\phi1$ is high (+$V_D$) and $\phi2$ is low (-$V_D$). In Phase 2, the signals are reversed. During Phase 1, the flying capacitor $C_{11}$ 50 charges up to -Vo. In Phase 2, this accumulated charge in $C_{11}$ is reversed and discharged to the output ($V_{IICP}$ 12), serving as the input voltage for the second charge pump 3. The inverse happens in the lower half part of the circuit. In Phase I the $V_{IICP}$ voltage is supplied by $C_{12}$ 51, and in Phase II the $C_{12}$ is charged. Consequently, a constant voltage of about +$V_D$ is maintained at the output of the first charge pump 2 in the steady state.

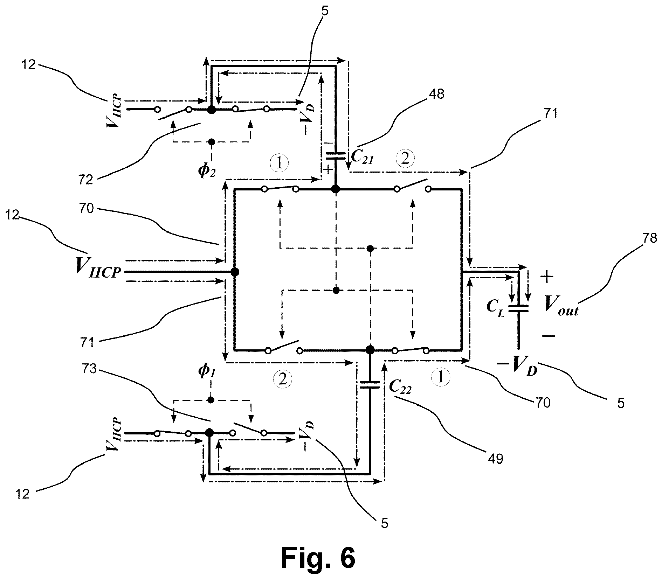

Fig. 6 illustrates an embodiment of the second charge pump 3 working principle during the first semi-period (Phase I) shown with arrows 70 and the second semi-period (Phase II) shown with arrows 71. In this embodiment, clock drivers 9 consist of an inverter and are simplified, with pairs of switches 72 and 73. The operational principles of the circuit in steady state is as follow: during Phase I, $\phi1$ is high and $\phi2$ is low; capacitor $C_{21}$ 48 is connected between $V_{IICP}$ 12 and -$V_D$ 5, which effectively charges the capacitor to $VC_{21} = 2V_D$. During the same semi-period, output voltage is set by the connection of $V_{IICP} = V_D$ in series with capacitor $C_{22}$ 49 (that

is pre-charged to $VC_{22} = 2V_D$ during the previous semi-period) and the floating ground of $-V_D$, which effectively sets the output voltage to $V_{out} = V_{IICP} + VC_{22} - (-V_D) = 4V_D$ 78. During Phase II, the inverse happens: $\phi1$ is low and $\phi2$ is high; capacitor $C_{22}$ is charged and output voltage is set by $V_{IICP}$, $C_{21}$ voltage and $-V_D$, also keeping output voltage to $4V_D$.

The described electronic circuits, by design, include parasitic diodes as outlined during the FEOL description. These diodes are, by design, cut-off by reverse biasing, so they do not modify the correct functioning of the circuit. However, under a source of light, they also generate photo-generated currents, which would lead to a circuit malfunction. To prevent this, in some embodiments of the present invention, all electronic circuits (except the energy harvesters) are covered by upper metal layers available in the BEOL part. These metal sheets need to cover the electronics, extending several tens to hundreds of micrometers over the circuit sides, to minimize light reflections.

The scope of the present invention is defined in the following set of claims.

## Claims

1. A light energy harvesting integrated circuit, comprising:

   a first energy harvester including a negative photodiode (1) to harvest light energy from incident light and to generate a negative voltage (5) as a result; and
   a power management stage including:

   a first charge pump (2) to invert the generated negative voltage (5) into a positive voltage;
   a second charge pump (3) to boost the positive voltage a given pumping factor at an output of the light energy harvesting integrated circuit; and
   a clock generator (6) to generate complementarily clock driving signals ($\phi_1$, $\phi_2$) to drive the first and second charge pumps (2, 3), the second charge pump (3) being further driven using clock drivers (9).

2. The light energy harvesting integrated circuit of claim 1, wherein the clock generator (6) is a light-supplied clock generator and is powered by a second energy harvester including a negative photodiode (7) and a positive photodiode (8).

3. The light energy harvesting integrated circuit of claim 2, wherein dimensions of the negative (7) and positive (8) photodiodes are sized to provide the same energy to the clock generator (6).

4. The light energy harvesting integrated circuit of any one of the previous claims, wherein the clock drivers (9) are supplied by the negative voltage (5) and an output voltage of the first charge pump (12), the latter being like the positive voltage.

5. The light energy harvesting integrated circuit of any one of the previous claims, wherein the clock generator (6) comprises a ring oscillator (20) configured to operate at an oscillation frequency that is based on an intensity of the incident light.

6. The light energy harvesting integrated circuit of claim 5, further comprising a Maximum Power Point Tracker, MPPT, circuit connected to the output of the light energy harvesting integrated circuit.

7. The light energy harvesting integrated circuit of any one of the previous claims, further comprising a load (4) that is connected to the output of the light energy harvesting integrated circuit.

8. The light energy harvesting integrated circuit of claim 7, wherein the given pumping factor is four by connecting a negative terminal of the load (4) to the negative voltage (5) and using it as a floating ground.

9. The light energy harvesting integrated circuit of claim 7, wherein the given pumping factor is three by connecting a negative terminal of the load (4) to ground.

10. The light energy harvesting integrated circuit of any one of the previous claims 7-9, wherein the load (4) comprises a low dropout regulator (10) to adjust the boosted positive voltage.

11. The light energy harvesting integrated circuit of any one of the previous claims 7-9, wherein the load (4) comprises a battery charging circuit (10).

12. The light energy harvesting integrated circuit of any one of the previous claims 7-11, wherein the load (4) further comprises a reservoir capacitor (11) to store the boosted positive voltage.

13. The light energy harvesting integrated circuit of claim 12, wherein the reservoir (11) comprises an on chip Metal-Insulator-Metal, Metal-Oxide-Metal, or Metal-Oxide Semiconductor Capacitor.

14. The light energy harvesting integrated circuit of claim 12, wherein the reservoir (11) comprises an off-chip reservoir including off-the-shelf capacitors or supercapacitors.

15. The light energy harvesting integrated circuit of claim 12, wherein the reservoir (11) comprises a battery.

## Fig. 1 (State of the Art)

## Fig. 2

# Fig. 3

# Fig. 4

**Fig. 5**

**Fig. 6**

Europäisches
Patentamt

European
Patent Office

Office européen
des brevets

## EUROPEAN SEARCH REPORT

**Application Number**

EP 24 38 2831

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/049319 A1 (MEYNANTS GUY [BE]) 19 February 2009 (2009-02-19) * paragraphs [0046], [0050], [0051], [0053], [0059], [0074], [0079], [0080] - [0082], [0096]; figures 1-9,11,12; table 1 * | 1-15 | INV. H02M3/07 H02M1/08 H02M1/00 H03K3/03 H03L7/099 |
| A | US 2020/321948 A1 (BOSE SOUMYA [US] ET AL) 8 October 2020 (2020-10-08) * paragraphs [0066], [0115]; figure 11 * | 1-15 | |
| A | FAN SHIQUAN ET AL: "A Two-Step Self-Startup Hybrid Structure Step-Up Converter Using Standard 5P0 MOSFETs Achieving 36 x Voltage Boosting With 50 mV Input Voltage and 84 x Input Voltage Range for Self-Powered IoT Applications", IEEE TRANSACTIONS ON POWER ELECTRONICS, INSTITUTE OF ELECTRICAL AND ELECTRONICS ENGINEERS, USA, vol. 38, no. 12, 12 September 2023 (2023-09-12), pages 15768-15780, XP011952146, ISSN: 0885-8993, DOI: 10.1109/TPEL.2023.3314437 [retrieved on 2023-09-13] * abstract; figures 2-4 * | 1-15 | TECHNICAL FIELDS SEARCHED (IPC) H02M H03K H03L |

-/--

The present search report has been drawn up for all claims

| Place of search | Date of completion of the search | Examiner |
|---|---|---|
| The Hague | 16 December 2024 | Kanelis, Konstantin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................................

& : member of the same patent family, corresponding document

EPO FORM 1503 03.82 (P04C01)

page 1 of 3

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CEVIK ISMAIL ET AL: "An Ultra-Low Power Energy Harvesting and Imaging (EHI) Type CMOS APS Imager With Self-Power Capability", IEEE TRANSACTIONS ON CIRCUITS AND SYSTEMS I: REGULAR PAPERS, IEEE, US, vol. 62, no. 9, 1 September 2015 (2015-09-01), pages 2177-2186, XP011667681, ISSN: 1549-8328, DOI: 10.1109/TCSI.2015.2451892 [retrieved on 2015-08-28] * abstract; figures 2,3 * | 1-15 | |
| A | ISMAIL YOUSR ET AL: "A 36-V 49% Efficient Hybrid Charge Pump in Nanometer-Scale Bulk CMOS Technology", IEEE JOURNAL OF SOLID-STATE CIRCUITS, IEEE, USA, vol. 52, no. 3, 1 March 2017 (2017-03-01), pages 781-798, XP011641922, ISSN: 0018-9200, DOI: 10.1109/JSSC.2016.2636876 [retrieved on 2017-02-27] * Subsection IV. C Improved-Drive Dickson Charge Pump; figure 21 * | 1-15 | |
| A | US 2008/218250 A1 (KIMURA TAIKI [JP] ET AL) 11 September 2008 (2008-09-11) * paragraphs [0039], [0046], [0049]; figures 2,3 * | 1-15 | |
| A | US 2013/051138 A1 (KWON DUK-MIN [KR] ET AL) 28 February 2013 (2013-02-28) * paragraphs [0059], [0060], [0064], [0069]; figure 3A * | 1-15 | |

**TECHNICAL FIELDS SEARCHED (IPC)**

-/--

The present search report has been drawn up for all claims

| Place of search | Date of completion of the search | Examiner |
|---|---|---|
| The Hague | 16 December 2024 | Kanelis, Konstantin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P04C01)

**EUROPEAN SEARCH REPORT**

Application Number

EP 24 38 2831

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2004/246044 A1 (MYONO TAKAO [JP] ET AL) 9 December 2004 (2004-12-09) * paragraphs [0036], [0083]; figure 3 * | 1-15 | |
| A | US 6 496 056 B1 (SHOJI MASAKAZU [US]) 17 December 2002 (2002-12-17) * figure 9 * | 1-15 | |
| A | CN 111 769 832 A (UNIV TIANJIN) 13 October 2020 (2020-10-13) * abstract; figure 3 * | 1-15 | |

TECHNICAL FIELDS
SEARCHED (IPC)

The present search report has been drawn up for all claims

| Place of search | Date of completion of the search | Examiner |
|---|---|---|
| The Hague | 16 December 2024 | Kanelis, Konstantin |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

page 3 of 3

## ANNEX TO THE EUROPEAN SEARCH REPORT
## ON EUROPEAN PATENT APPLICATION NO.

EP 24 38 2831

This annex lists the patent family members relating to the patent documents cited in the above-mentioned European search report.
The members are as contained in the European Patent Office EDP file on
The European Patent Office is in no way liable for these particulars which are merely given for the purpose of information.

16-12-2024

| Patent document cited in search report | | Publication date | Patent family member(s) | | Publication date |
|---|---|---|---|---|---|
| US 2009049319 | A1 | 19-02-2009 | EP | 2017946 A1 | 21-01-2009 |
| | | | US | 2009049319 A1 | 19-02-2009 |
| US 2020321948 | A1 | 08-10-2020 | US | 2020321862 A1 | 08-10-2020 |
| | | | US | 2020321948 A1 | 08-10-2020 |
| US 2008218250 | A1 | 11-09-2008 | CN | 101272091 A | 24-09-2008 |
| | | | JP | 4925866 B2 | 09-05-2012 |
| | | | JP | 2008211957 A | 11-09-2008 |
| | | | KR | 20080080027 A | 02-09-2008 |
| | | | TW | 200843347 A | 01-11-2008 |
| | | | US | 2008218250 A1 | 11-09-2008 |
| US 2013051138 | A1 | 28-02-2013 | KR | 20130024275 A | 08-03-2013 |
| | | | US | 2013051138 A1 | 28-02-2013 |
| US 2004246044 | A1 | 09-12-2004 | CN | 1543073 A | 03-11-2004 |
| | | | KR | 20040089535 A | 21-10-2004 |
| | | | TW | 200505162 A | 01-02-2005 |
| | | | US | 2004246044 A1 | 09-12-2004 |
| US 6496056 | B1 | 17-12-2002 | EP | 1037388 A2 | 20-09-2000 |
| | | | JP | 4043683 B2 | 06-02-2008 |
| | | | JP | 2000260951 A | 22-09-2000 |
| | | | KR | 20000076776 A | 26-12-2000 |
| | | | TW | 521393 B | 21-02-2003 |
| | | | US | 6496056 B1 | 17-12-2002 |
| CN 111769832 | A | 13-10-2020 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170110444 A1, Chang-Hong ShenJia-Min ShiehWen-Hsien HuangTsung-Ta WuChih-Chao YangTung-Ying Hsieh

- US 20170133938 A1, Eugen Tiefnig

**Non-patent literature cited in the description**

- **G. MOAYERI POUR** ; **M. K. BENYHESAN** ; **W. D. LEON-SALAS**. Energy Harvesting Using Substrate Photodiodes. *IEEE Transactions on Circuits and Systems II: Express Briefs*, July 2014, vol. 61 (7), 501-505
- **M. K. LAW** ; **A. BERMAK**. High-Voltage Generation With Stacked Photodiodes in Standard CMOS Process. *IEEE Electron Device Letters*, December 2010, vol. 31 (12), 1425-1427
- **J. MADRENAS** ; **D. FERNÁNDEZ** ; **C. WANG**. LCMOS: Light-powered standard CMOS circuits. *2012 IEEE International Symposium on Circuits and Systems (ISCAS), Seoul, Korea (South)*, 2012, 3029-3032
- **J. MADRENAS** ; **J. M. SÁNCHEZ-CHIVA** ; **D. FERNÁNDEZ** ; **J. COSP**. Design Considerations for Analog LCMOS Harvest-Use Integrated Signal Processing. *2019 IEEE International Symposium on Circuits and Systems (ISCAS), Sapporo, Japan*, 2019, 1-5

- **S. GHOSH** ; **H. -T. WANG** ; **W. D. LEON-SALAS**. A Circuit for Energy Harvesting Using On-Chip Solar Cells. *IEEE Transactions on Power Electronics*, September 2014, vol. 29 (9), 4658-4671
- **H. KIM** ; **J. MAENG** ; **I. PARK** ; **J. JEON** ; **D. LIM** ; **C. KIM**. A 90.2% Peak Efficiency Multi-Input Single-Inductor Multi-Output Energy Harvesting Interface With Double-Conversion Rejection Technique and Buck-Based Dual-Conversion Mode. *IEEE Journal of Solid-State Circuits*, March 2021, vol. 56 (3), 961-971
- **WU et al.** *A 20-pW Discontinuous Switched-Capacitor Energy Harvester for Smart Sensor Applications*
- **X. LIU** ; **E. SÁNCHEZ-SINENCIO**. An 86% Efficiency 12 $\mu$W Self-Sustaining PV Energy Harvesting System With Hysteresis Regulation and Time-Domain MPPT for IOT Smart Nodes. *IEEE Journal of Solid-State Circuits*, June 2015, vol. 50 (6), 1424-1437